# EUROPEAN PATENT SPECIFICATION

(11) **EP 1 777 320 B1**
(45) Date of publication and mention of the grant of the patent: **10.08.2011**
(21) Application number: 06255434.0
(22) Date of filing: 23.10.2006
(51) Int. Cl.: C23C 14/24, C23C 14/12, C23C 14/54

(54) **Apparatus and method for depositing thin films**
Vorrichtung und Verfahren zur Herstellung von Dünnfilmen
Dispositif et procédé pour le dépôt de films minces

(30) Priority: 21.10.2005 KR 20050099909
(43) Date of publication of application: 25.04.2007
(73) Proprietor: Samsung Mobile Display Co., Ltd., Suwon-si Gyeonggi-do (KR)
(72) Inventor: Huh, Myung Soo, Legal & IP Team, Yongin-si Gyeonggi-do (KR); Ahn, Jae Hong, Legal & IP Team, Yongin-si Gyeonggi-do (KR); Han, Sang Jin, Legal & IP Team, Yongin-si Gyeonggi-do (KR)
(74) Representative: Mounteney, Simon James

(56) References cited:
- JP-A- 58 018 671
- US-A1- 2003 173 031
- US-A1- 2003 221 702
- US-A1- 2004 139 984

## Description

### BACKGROUND OF THE INVENTION

### 1. Field of the Invention

The present invention relates to an apparatus and method for depositing thin films. In particular, the present invention relates to an apparatus and method for depositing thin films capable of maintaining stable temperature and deposition rate, thereby providing improved control of film thickness.

### 2. Discussion of the Related Art

Deposition of thin films has numerous manufacturing applications. In semiconductor manufacturing, for example, thin films may be deposited in display devices, such as electroluminescent (EL) display devices, to provide photon-emitting mediums to form images. The thin film of the EL display device, for example, may include a plurality of functional layers, e.g., a hole injecting layer, a hole transporting layer, an emission layer, an electron transporting layer, an electron injecting layer, a buffer layer, and/or a carrier blocking layer, that may be arranged in different configurations for achieving a specific function of the EL display device.

Thin films may be applied to a substrate, e.g., an electrode, by methods such as physical vapor deposition (PVD), e.g., vacuum deposition, chemical vapor deposition (CVD), ion plating, sputtering, and so forth. In the vacuum deposition method, for example, a vacuum environment, e.g., vacuum chamber, may be provided with a deposition material, e.g., organic light-emitting material, and a substrate. An evaporation source having a heating unit may be either connected to the vacuum environment or installed therein, such that the operation of the evaporation source may evaporate the deposition material and apply it to a substrate to form a thin film thereon.

US2004/0139984 A1 discloses a film-forming apparatus comprising a substrate holder 202 provided in a film-forming chamber 201, a substrate 203 supported by the substrate holder 202 and a vapor-deposition source. Further, an adhesion preventing shield 206 is provided so as to surround the substrate 203, the vapor-deposition mask 204, and the mask holder 205. A region denoted with 207 in the adhesion preventing shield 206 can cover a vapor-deposition source until a sublimation speed of a vapor-deposition material is stabilized.

However, application of evaporated material onto a substrate may cause non-uniform temperature around the substrate, thereby triggering non-uniform deposition rate and film thickness.

Accordingly, there remains a need for a thin film deposition apparatus and a method employing the same for maintaining stable temperature in order to provide improved control of deposition rate and film thickness.

### SUMMARY OF THE INVENTION

The present invention is therefore directed to an apparatus for depositing thin films and method of producing the same, which substantially overcome one or more of the disadvantages of the related art.

In particular, the present invention sets out to provide an apparatus for depositing thin films that can provide improved temperature uniformity inside a processing chamber.

The present invention also particularly aims to provide a method of depositing thin films that offers an improved control over temperature and film thickness.

At least one of the above and other features and advantages of the present invention may be realized by providing an apparatus for depositing thin films as set out in Claim 1.

The heat absorbing plate may be formed of a ceramic-based material. Alternatively, the heat absorbing plate may include a blacking layer formed thereon between the heat absorbing plate and the evaporation source. The blacking layer may be formed to a thickness ranging from about 10 µm to about 100 µm.

The film forming part may include a mask placed between the substrate and the evaporation source. The apparatus according to an embodiment of the present invention may include a deposition rate measuring unit. Additionally, the apparatus according to an embodiment of the present invention may include a supporting unit for securing the substrate in the film forming part. The processing chamber may be a vacuum chamber.

According to another aspect of the present invention, there is provided a method of depositing thin films as set out in Claim 9.

Forming of the heat absorbing plate may include forming a blacking layer having a thickness of from about 10 µm to about 100 µm on the heat absorbing plate between the heat absorbing plate and the evaporation source. Forming the blacking layer may include any one of a phosphate coating processing, and a chromate coating processing.

Operating the evaporation source may include evaporating an organic light-emitting deposition material. Forming a film forming part and a deposition preventing part may further include providing a vacuum environment in the processing chamber. Additionally, the inventive method may include operating a deposition rate measuring unit.

### BRIEF DESCRIPTION OF THE DRAWINGS

The above and other features and advantages of the present invention will become more apparent to those of ordinary skill in the art by making reference to the following description in which embodiments of the invention are described by way of example and with reference to the attached drawings, in which:

FIG. 1 is a perspective view of an apparatus for depositing thin films according to an embodiment of the present invention;

FIG. 2 is a sectional view of an apparatus for depositing thin films taken along line I-I' of FIG. 1;

FIG. 3 is a plan view of a substrate with respect to a heat absorbing plate according to an embodiment of the present invention; and

FIG. 4 is a perspective view of an evaporation source according to an embodiment of the present invention.

### DETAILED DESCRIPTION OF THE INVENTION

The present invention will now be described more fully hereinafter with reference to the accompanying drawings, in which exemplary embodiments of the invention are illustrated. The invention may, however, be embodied in different forms and should not be construed as limited to the embodiments set forth herein. Rather, these embodiments are provided so that this disclosure will be thorough and complete, and will fully convey the scope of the invention to those skilled in the art.

In the figures, the dimensions of layers and elements may be exaggerated for clarity of illustration. It will also be understood that when a layer or element is referred to as being "on" another layer, element, or substrate, it can be directly on the other layer, element, or substrate, or intervening layers/elements may also be present. Further, it will be understood that when a layer or element is referred to as being "under" another layer or element, it can be directly under, or one or more intervening layers or elements may also be present. In addition, it will also be understood that when a layer or element is referred to as being "between" two layers or elements, it can be the only layer or element between the two layers/elements, or one or more intervening layers or elements may also be present. Like reference numerals refer to like elements throughout.

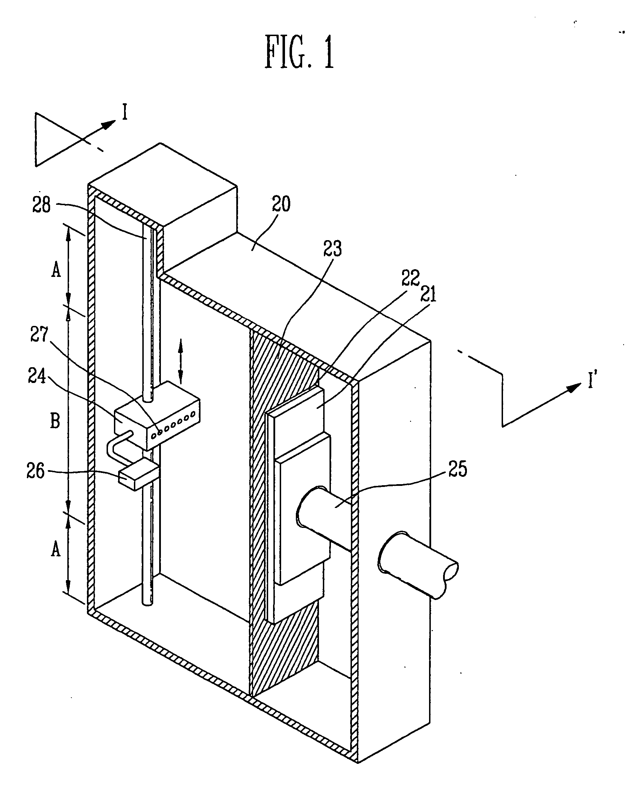

An embodiment of an apparatus in accordance with the present invention will now be more fully described with reference to FIGS. 1 and 3-4.

As illustrated in FIG. 1, an apparatus for depositing thin films according to an embodiment of the present invention includes a processing chamber 20, an evaporation source 24, and a heat absorbing plate 23.

The processing chamber 20 may be any type of vessel known by those skilled in the art for use in film processing, and, preferably, it may be a pressure-controlled vessel such as a vacuum chamber. The processing chamber 20 is in this particular case formed to have a deposition preventing part A and a film forming part B.

The film forming part B, as illustrated in FIG. 1, is located in a central area of processing chamber 20. The central area of processing chamber 20 corresponds to the position where a substrate is placed and formation of a film, e.g., vacuum deposition processing, occurs. The deposition preventing part A, as illustrated in FIG. 1, refers to the area inside the processing chamber 20 that surrounds the film forming part B. In other words, the deposition preventing part A is formed as peripheral portions of film forming part B. The peripheral portions, i.e., deposition preventing part A, are excluded from film deposition processing.

As illustrated in FIG. 1, during a substrate 21 and a mask 22 may be placed in the film forming part B of processing chamber 20. In particular, the substrate 21 may be placed in the center of the processing chamber 20, i.e., film forming part B, facing the evaporation source 24, such that the deposition preventing part A surrounds it. The mask 22 may be attached to the substrate 21 between the substrate 21 and the evaporation source 24. The mask 22 typically includes a pattern formation unit (not shown) having a pattern corresponding to a pattern to be imparted to a thin film formed on the substrate 21, and a fixation unit (not shown) secured to a mask frame (not shown) through welding.

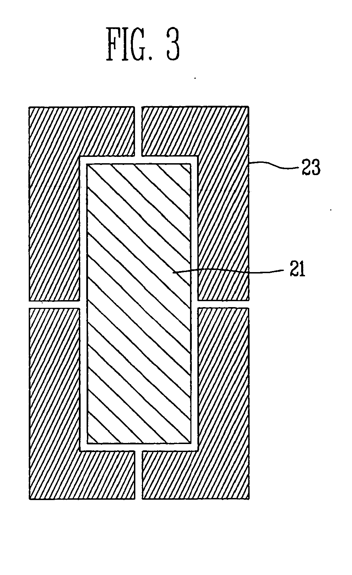

The heat absorbing plate 23 of this embodiment of the present invention is formed in the deposition preventing part A of the processing chamber 20, as illustrated in FIG. 1. In other words, the heat absorbing plate 23 is formed only in the peripheral portions of the processing chamber 20, such that the heat absorbing plate 23 surrounds the substrate 21 placed in the film forming part B of the processing chamber 20 in order to absorb any potential excess heat radiated from the evaporation source 24 to the substrate 21. In this particular case, a heat absorbing plate 23 is divided into four parts, such that the four parts are arranged as a frame around the substrate 21, as shown in FIG 3, although other configurations are possible.

The heat absorbing plate 23 may be formed of any suitable material known in the art in order to enhance heat absorption. For example, the heat absorbing plate 23 may be formed of a ceramic-based material. Alternatively, the heat absorbing plate 23 may be coated with a blacking layer having a thickness ranging from about 10 µm to about 100 µm. The blacking layer may be formed of any known blacking agent known in the art, e.g., an opaque material, in order to enhance heat absorption of the heat absorbing plate 23.

The heat absorbing plate 23 absorbs heat in the processing chamber 20 and, thereby, reduces potential excess heat surrounding the substrate 21 and improves its temperature uniformity. Without intending to be bound by theory, it is believed that uniform temperature provides a uniform deposition rate, e.g., deposition rate no more than about 1.0 angstrom/s, thereby improving control of film thickness.

The formation of the blacking layer may be referred to as a blacking process. In particular, the blacking process may be performed by any method known in the art, such as, for example, phosphate coating, igneous base coating, and chromate coating. For example, in the phosphate coating process, an etchant, i.e., phosphate, may be applied by a chemical or electro-chemical reaction to a metallic layer to form a corrosion product layer, i.e., a phosphate coating film. Alternatively, in the chromate coating process, a solution of chromate or dichromate may be applied to a substrate, i.e., a material to be chromate-coated, to form a chromate coating film.

In use, the evaporation source 24 is charged with a deposition material for forming a thin film. The deposition material may be any type of material employed in the art for forming thin films. For example, where the thin film is to be used in a display device, the deposition material may be a light-emitting material, such as an organic light-emitting material.

The evaporation source 24 provides sufficient heat to vaporize the deposition material therein, and, subsequently, apply it onto the substrate 21. To facilitate this, the evaporation source 24 has an outlet that is in fluid communication with the processing chamber 20 (although other embodiments will include several).The evaporation source 24 is, in this case, formed on a shaft 28 inside a processing chamber 20.

The shaft 28 is arranged parallel to the substrate 21 inside the processing chamber 20, and includes a rotary unit (not shown) that may rotate and move the evaporation source 24 along the shaft 28. Accordingly, the evaporation source 24 is a moveable unit that may perform vertical or horizontal film deposition onto the substrate 21.

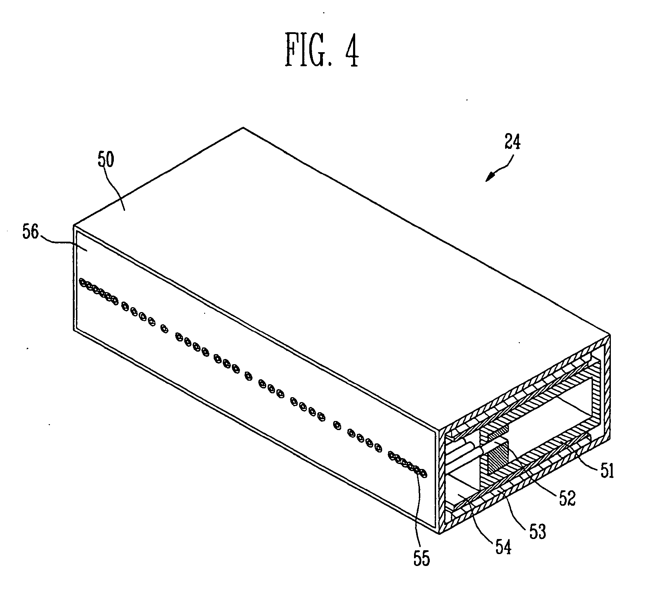

The detailed structure of the evaporation source 24 will be described in more detail with respect to FIG. 4. The evaporation source 24 includes a furnace 51 for storing the deposition material, two heating units 54, two reflectors 53, an insulating plate 56, row of spray nozzles 55, and induction channels 52 for guiding the evaporated deposition material from the furnace 51 to the spray nozzle 55. The evaporation source 24 also includes a housing 50 to enclose all the above components.

The housing 50 may be formed to include a double wall having an internal wall (not shown) and an external wall (not shown). The double wall structure may provide sufficient space therebetween for holding cooling water to facilitate temperature control.

The furnace 51 is charged with the deposition material to be deposited onto the substrate 21, and it may be formed of any material known in the art that has excellent heat conductivity. In particular, the furnace 51 may be formed of a ceramic material, e.g., graphite, silicon carbide (SiC), aluminum nitride (AIN), alumina (Al₂O₃), boron nitride (BN), quartz, and so forth, or of a metal, e.g., titanium (Ti), stainless steel, and so forth.

Each heating unit 54 includes an electrical heater (not shown) and is formed on each longitudinal side of the furnace 51, as illustrated in FIG. 4. The evaporation source 24 may alternatively include a different of heating units 54, the or each heating unit 54 having at least one electrical heater. As such, the heating units 54 are formed in close proximity to the furnace 51 to provide sufficient heat to evaporate the deposition material contained therein.

A reflector 53 is provided between each heating unit 54 and the housing 50 surrounding the furnace 51. The reflectors 53 are formed in close proximity to the heating units 54 to reflect heat emitted from the heating units 54 into the furnace 51, and, thereby, to minimize heat leakage outside the evaporation source 24.

The spray nozzles 55 are formed through the housing 50, and face the substrate 21. In alternative embodiments, different numbers of spray nozzles are provided.

The insulating plate 56 is formed between the furnace 51 and a wall of the housing 50 facing the substrate 21, such that heat transfer from the induction channels 52 through the nozzles 55 into the film forming part B of the processing chamber 20 and the substrate 21 may be minimized.

In accordance with the present invention, the apparatus also includes an optional deposition rate measuring unit 26 affixed to the evaporation source 24, such that the deposition rate measuring unit 26 and the evaporation source 24 may move jointly along the shaft 28. The deposition rate measuring unit 26 may alternatively be integral to the evaporation source 24. The joint motion of the deposition rate measuring unit 26 and the evaporation source 24, whether integrated or not, allows continuous real-time measurement of the evaporation rate of the deposition material and control of its deposition rate onto the substrate 21.

The deposition rate measuring unit 26 may also have the capability of adjusting the evaporation rate of the deposition material in order to achieve a specific deposition rate onto the substrate 21. For example, the deposition rate measuring unit 26 may be electrically connected to the heating unit 54 of the evaporation source 24, such that the heat amount generated for evaporating the deposition material in the evaporation source 24 may be increased or decreased with respect to a desired deposition rate. Similarly, the deposition rate measuring unit 26 may be electrically connected to the rotary unit of the shaft 28, such that the speed at which the evaporation source 24 moves along shaft 28 may be increased or decreased with respect to the amount of the evaporated deposition material. The control of the evaporation source 24 speed may facilitate control of the exposure time of the substrate 21 to the evaporation source 24, i.e., deposition rate.

The apparatus for forming films further includes a supporting unit 25. The supporting unit 25 is coupled to the processing chamber 20 in order to secure the substrate 21 and the mask 22 in the film forming part A of the processing chamber 20, as illustrated in FIG. 1. The supporting unit 25 is in this case formed as a longitudinal member with a flat perpendicular plate attached thereto, i.e., T-shaped, connected to the processing chamber 20 at one end and to the substrate 21 at the other end, such that the substrate 21 may be stably secured in its position. Additionally, an alignment system (not shown) may be added to align the substrate and a mask thereon.

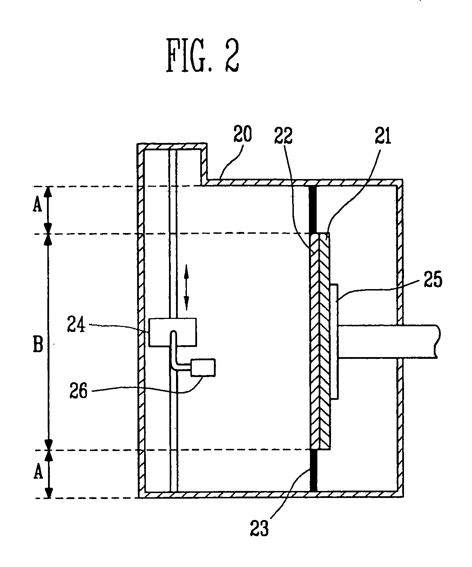

Ae method of depositing a thin film onto a substrate is described below with reference to FIG. 2, which is a sectional view taken along the line I-I' of FIG. 1.

Once the apparatus and its components are set, a deposition material, e.g., a metal or a light-emitting material such as an organic light-emitting material employed in manufacturing of organic light-emitting diodes (OLEDs), may be placed in the evaporation source 24. Next, the evaporation source 24 may be operated to evaporate, e.g., gasify or sublimate, the deposition material. Preferably, the evaporation temperatures in the evaporation source 24 are low, i.e., temperatures ranging from about 200°C to about 400°C.

The evaporated deposition material may be applied to the substrate 21 by any means known in the art, e.g., spraying. During application to the substrate 21, the deposition material may undergo additional continuous processes, e.g., adsorption, deposition, re-evaporation, and so forth. Once the deposition material is successfully applied to the substrate 21, it may solidify to form a thin film.

It should also be noted that evaporation and deposition of the deposition material may occur simultaneously while the evaporation source 24 moves along such shaft. The deposition rate measuring unit 26 moves jointly with the evaporation source 24 to measure and adjust the evaporation rate of the deposition material and its deposition rate onto the substrate 21. Alternatively, an embodiment of a stationary evaporation source and moveable substrate is not excluded from the scope of this invention.

Embodiments of the present invention have been disclosed herein by way of example, and although specific terms are employed, they are used and are to be interpreted in a generic and descriptive sense only and not for purpose of limitation. Accordingly, it will be understood by those of ordinary skill in the art that various changes in form and details may be made without departing from the scope of the present invention as set forth in the following claims.

## Claims

1. An apparatus for depositing thin films, comprising:
a processing chamber (20) having a film forming part and a deposition preventing part, the deposition preventing part being peripheral to the film forming part;
an evaporation source (24) in fluid communication with the processing chamber (20) for accommodating a deposition material; and
a heat absorbing plate (23) formed in the deposition preventing part of the processing chamber (20), wherein the heat absorbing plate (23) is:
positioned to surround a substrate (21) placed in the film forming part of the processing chamber (20); and
formed as a plurality of spaced apart parts arranged as a frame around the substrate.

2. Apparatus as claimed in claim 1, wherein the heat absorbing plate comprising a blacking layer is formed on the heat absorbing plate (23) between the heat absorbing plate (23) and the evaporation source.

3. Apparatus as claimed in claim 2, wherein the blacking layer is formed to a thickness ranging from 10 µm to 100 µm.

4. Apparatus as claimed in claim 1, wherein the heat absorbing plate (23) is formed of a ceramic-based material.

5. Apparatus as claimed in any preceding claim, wherein the film terming part comprises a mask placed between the substrate and the evaporation source outlet.

6. Apparatus as claimed in any preceding claim, further comprising a deposition rate measuring unit (26).

7. Apparatus as claimed in any preceding claim, further comprising a supporting unit for securing the substrate in the film forming part.

8. Apparatus as claimed in any preceding claim, wherein the processing chamber is a vacuum chamber.

9. A method of depositing thin films, comprising:
forming a film forming part and a deposition preventing part in a processing chamber (20), the deposition preventing part being peripheral to the film forming part;
providing an evaporation source (24) having at least one heating unit, at least one nozzle, and a deposition material;
placing a substrate (21) in the film forming section, such that a surface of the substrate (21) to be coated is facing the evaporation source;
forming a heat absorbing plate (23) in the deposition preventing section,
such that the heat absorbing plate (23) surrounds the substrate and absorbs heat generated by the evaporation source heating unit, and is formed as a plurality of spaced apart parts arranged as a frame around the substrate (21);
operating the evaporation source to evaporate the deposition material; and
releasing the evaporated deposition material through the evaporation source nozzle onto the substrate to form a film.

10. A method as claimed in claim 9, wherein forming the heat absorbing plate (23) comprises forming a blacking layer having a thickness of from about 10 µm to about 100 µm on the heat absorbing plate between the heat absorbing plate (23) and the evaporation source.

11. A method as claimed in claim 10, wherein forming the blacking layer includes any one of a phosphate coating processing, and a chromate coating processing.

12. A method as claimed in claim 9 or 10, wherein operating the evaporation source comprises evaporating an organic light-emitting material.

13. A method as claimed in any of claim 9 to 12 , wherein forming a film forming part and a deposition preventing part further comprises providing a vacuum environment in the processing chamber.

14. A method as claimed in any of claims 9 to 13, further comprising operating a deposition rate measuring unit.

## Patentansprüche

1. Vorrichtung zum Abscheiden von Dünnfilmen, umfassend:
eine Verarbeitungskammer (20) mit einem Filmbildungsteil und einem Abscheidungsverhinderungsteil, wobei der Abscheidungsverhinderungsteil peripher zum Filmbildungsteil ist;
eine Bedampfungsquelle (24) in Fluidverbindung mit der Verarbeitungskammer (20) zur Aufnahme eines Abscheidematerials; und
eine Wärmeabsorptionsplatte (23), die im Abscheidungsverhinderungsteil der Verarbeitungskammer (20) ausgebildet ist, wobei die Wärmeabsorptionsplatte (23):
derart positioniert ist, dass sie ein Substrat (21) umgibt, das im Filmbildungsteil der Verarbeitungskammer (20) angeordnet ist; und
als eine Mehrzahl von voneinander beabstandeten Teilen ausgebildet ist, die als ein Rahmen um das Substrat angeordnet sind.

2. Vorrichtung nach Anspruch 1, wobei die Wärmeabsorptionsplatte, die eine Schwärzungsschicht umfasst, auf der Wärmeabsorptionsplatte (23) zwischen der Wärmeabsorptionsplatte (23) und der Bedampfungsquelle ausgebildet ist.

3. Vorrichtung nach Anspruch 2, wobei die Schwärzungsschicht zu einer Dicke im Bereich von 10 µm bis 100 µm ausgebildet ist.

4. Vorrichtung nach Anspruch 1, wobei die Wärmeabsorptionsplatte (23) aus einem Material auf Keramikbasis gebildet ist.

5. Vorrichtung nach einem der vorhergehenden Ansprüche, wobei der Filmbildungsteil eine Maske umfasst, die zwischen dem Substrat und dem Auslass der Bedampfungsquelle angeordnet ist.

6. Vorrichtung nach einem der vorhergehenden Ansprüche, ferner umfassend eine Abscheideratenmesseinheit (26).

7. Vorrichtung nach einem der vorhergehenden Ansprüche, ferner umfassend eine Trageinheit zum Befestigen des Substrats im Filmbildungsteil.

8. Vorrichtung nach einem der vorhergehenden Ansprüche, wobei die Verarbeitungskammer eine Vakuumkammer ist.

9. Verfahren zum Abscheiden von Dünnfilmen, umfassend:
Bilden eines Filmbildungsteils und eines Abscheidungsverhinderungsteils in einer Verarbeitungskammer (20), wobei der Abscheidungsverhinderungsteil peripher zum Filmbildungsteil ist;
Bereitstellen einer Bedampfungsquelle (24) mit mindestens einer Heizeinheit, mindestens einer Düse und eines Abscheidematerials;
derartiges Anordnet eines Substrats (21) im Filmbildungsabschnitt, dass eine zu beschichtende Oberfläche des Substrats (21) der Bedampfungsquelle gegenüberliegt;
derartiges Ausbilden einer Wärmeabsorptionsplatte (23) im Abscheidungsverhinderungsabschnitt, dass die Wärmeabsorptionsplatte (23) das Substrat umgibt und Wärme absorbiert, die durch die Heizeinheit der Bedampfrungsquelle erzeugt wird, und als eine Mehrzahl von voneinander beabstandeten Teilen ausgebildet ist, die als ein Rahmen um das Substrat (21) angeordnet sind;
Betreiben der Bedampfungsquelle, um das Abscheidematerial zu verdampfen; und
Freisetzen des verdampften Abscheidematerials durch die Düse der Bedampfungsquelle auf das Substrat, um einen Film zu bilden.

10. Verfahren nach Anspruch 9, wobei das Bilden der Wärmeabsorptionsplatte (23) ein Bilden einer Schwärzungsschicht mit einer Dicke von etwa 10 µm bis etwa 100 µm auf der Wärmeabsorptionsplatte zwischen der Wärmeabsorptionsplatte (23) und der Bedampfungsquelle umfasst.

11. Verfahren nach Anspruch 10, wobei das Bilden der Schwärzuztgsschicht eine beliebige einer Phosphatbeschichtungsverarbeitung und einer Chromatbeschichtungsverarbeitung umfasst.

12. Verfahren nach Anspruch 9 oder 10, wobei das Betreiben der Bedampfungsquelle das Verdampfen eines organischen, Licht emittierenden Materials umfasst.

13. Verfahren nach einem der Ansprüche 9 bis 12, wobei das Bilden eines Filmbildungsteils und eines Abscheidungsverhinderungsteils ferner ein Bereitstellen einer Vakuumumgebung in der Verarbeitungskammer umfasst.

14. Verfahren nach einem der Ansprüche 9 bis 13, ferner umfassend ein Betreiben einer Abscheideratenmesseinbeit.

## Revendications

1. Appareil pour déposer des couches minces, comprenant :
une chambre de traitement (20) ayant une partie de formation de couche mince et une partie de prévention de dépôt, la partie de prévention de dépôt étant périphérique par rapport à la partie de formation de couche mince ;
une source d'évaporation (24) en communication fluidique avec la chambre de traitement (20) pour loger un matériau de dépôt ; et
une plaque d'absorption de chaleur (23) formée dans la partie de prévention de dépôt de la chambre de traitement (20), dans lequel la plaque d'absorption de chaleur (23) est :
positionnée de manière à entourer un substrat (21) placé dans la partie de formation de couche mince de la chambre de traitement (20) ; et
formée sous la forme d'une pluralité de parties espacées agencées sous la forme d'un cadre autour du substrat.

2. Appareil selon la revendication 1, dans lequel la plaque d'absorption de chaleur comprenant une couche d'enduit noir est formée sur la plaque d'absorption de chaleur (23) entre la plaque d'absorption de chaleur (23) et la source d'évaporation.

3. Appareil selon la revendication 2, dans lequel la couche d'enduit noir est formée à une épaisseur dans la plage de 10 µm à 100 µm.

4. Appareil selon la revendication 1, dans lequel la plaque d'absorption de chaleur (23) est formée d'un matériau à base de céramique.

5. Appareil selon l'une quelconque des revendications précédentes, dans lequel la partie de formation de couche mince comprend un masque placé entre le substrat et la sortie de la source d'évaporation.

6. Appareil selon l'une quelconque des revendications précédentes, comprenant en outre une unité de mesure de taux de dépôt (26).

7. Appareil selon l'une quelconque des revendications précédentes, comprenant en outre une unité de support pour fixer le substrat dans la partie de formation de couche mince.

8. Appareil selon l'une quelconque des revendications précédentes, dans lequel la chambre de traitement est une chambre à vide.

9. Procédé de dépôt de couches minces, comprenant :
la formation d'une partie de formation de couche mince et d'une partie de prévention de dépôt dans une chambre de traitement (20), la partie de prévention de dépôt étant périphérique par rapport à la partie de formation de couche mince;
la fourniture d'une source d'évaporation (24) ayant au moins une unité de chauffage, au moins une buse, et un matériau de dépôt ;
le placement d'un substrat (21) dans la section de formation de couche mince, de sorte qu'une surface du substrat (21) à revêtir soit face à la source d'évaporation ;
la formation d'une plaque d'absorption de chaleur (23) dans la section de prévention de dépôt, de sorte que la plaque d'absorption de chaleur (23) entoure le substrat et absorbe la chaleur générée par l'unité de chauffage de source d'évaporation, et soit formée sous la forme d'une pluralité de parties espacées agencées sous la forme d'un cadre autour du substrat (21) ;
le fonctionnement de la source d'évaporation pour évaporer le matériau de dépôt ; et
la libération du matériau de dépôt évaporé par la buse de la source d'évaporation sur le substrat pour former une couche mince.

10. Procédé selon la revendication 9, dans lequel la formation de la plaque d'absorption de chaleur (23) comprend la formation d'une couche d'enduit noir ayant une épaisseur d'environ 10 µm à environ 100 µm sur la plaque d'absorption de chaleur entre la plaque d'absorption de chaleur (23) et la source d'évaporation.

11. Procédé selon la revendication 10, dans lequel la formation de la couche d'enduit noir comprend l'un quelconque d'un traitement de couche de phosphate, et un traitement de couche de chromate.

12. Procédé selon la revendication 9 ou 10, dans lequel le fonctionnement de la source d'évaporation comprend l'évaporation d'un matériau luminescent organique.

13. Procédé selon l'une quelconque des revendications 9 à 12, dans lequel la formation d'une partie de formation de couche mince et une partie de prévention de dépôt comprend en outre la production d'un environnement de vide dans la chambre de traitement.

14. Procédé selon l'une quelconque des revendications 9 à 13, comprenant en outre le fonctionnement d'une unité de mesure de taux de dépôt.
